# EUROPEAN PATENT SPECIFICATION

(11) **EP 2 244 543 B1**
(45) Date of publication and mention of the grant of the patent: **04.03.2015**
(21) Application number: 10250793.6
(22) Date of filing: 20.04.2010
(51) Int. Cl.: H05K 5/02

(54) **Reconfigurable full authority digital electronic control housing**
Neukonfigurierbares Gehäuse für vollautomatische elektronische Steuerung
Boîtier de contrôle électronique numérique d'autorisation complète reconfigurable

(30) Priority: 20.04.2009 US 170835 P
(43) Date of publication of application: 27.10.2010
(73) Proprietor: Hamilton Sundstrand Corporation, Windsor Locks, CT 06096-1010 (US)
(72) Inventor: DiVincenzo, Gregory, Putman, CT 06260 (US); Hartman, Jay H., New Hartford, CT 06057 (US); Kamenetz, Jeffry K., Windsor, CT 06095 (US); Orsini, Luke T., Marlborough, CT 06447 (US)
(74) Representative: Tomlinson, Kerry John

(56) References cited:
- DE-A1- 19 921 928
- GB-A- 2 426 634

## Description

### BACKGROUND

The present disclosure is generally directed to electrical circuitry housing, and more specifically to a housing for a Full Authority Digital Electronic Control system.

Aircraft, as well as other vehicles, typically utilize Full Authority Digital Electronic Controllers (FADEC) to control multiple aspects of the engine operation. In aircraft applications, the FADEC often includes sensitive electronics, which should be protected from environmental elements to prevent unnecessary wear. When a dual channel FADEC (a FADEC which utilizes two channel inputs) is used, the FADEC housing is made larger to accommodate the two channel circuits as well as an interchannel communication line. To protect the FADEC circuitry from environmental elements, it is sealed within the FADEC housing. Electrical connections extend to outside electronics using standardized connectors.

Currently, FADEC housings are formed from metal blocks that are machined to a desired shape and dimensions. The housings also include a machined cover, which can be sealed to an opening in the housing body, created by the machining process, thereby enclosing and protecting the circuitry. Once the FADEC circuitry is installed and the cover is attached to the housing body, the electronic equipment is protected from external elements, such as weather. The housing also includes machined, fitted openings for standardized electrical connectors.

Some FADEC systems utilize dual channel FADECs. For example, a dual channel FADEC could be used in a system where it is desirable to control two engines from a single controller. In such a system the FADECs are connected together via a control wire or contained within the same housing, depending on physical design and space requirements. The dual channel FADECs may also include an interchannel communication device, further increasing the space requirements.

Each FADEC installation may have different dimensional requirements for the locations of the FADECs. For example one type of aircraft may require two FADECs housed in a single housing, and another type of aircraft may require each FADEC to be housed separately and connected through an external communication line. For this reason, each housing is currently custom built for the intended aircraft.

### SUMMARY

Disclosed is a configurable Full Authority Digital Electronic Controller (FADEC) which has a stamped housing body containing a FADEC circuit assembly and a cover which encloses the housing body. At least one electrical connector is mounted on the housing body and electrically coupled to the FADEC circuit assembly; see e.g. DE 199 21 928 A1.

The invention concerns a FADEC according to claim 1.

These and other features of the present invention can be best understood from the following specification and drawings, the following of which is a brief description.

### BRIEF DESCRIPTION OF THE DRAWINGS

Figure 1 is an example aircraft using a FADEC to control engine operation.
Figure 2A is an example configuration of a FADEC housing constructed using a stamped housing body.
Figure 2B is an exploded view of the example of Figure 2A.
Figure 3A is a second example configuration of a FADEC housing constructed using a stamped housing body.
Figure 3B is an exploded view of the example of Figure 3A.
Figure 4A is a diagrammatic description of a first possible FADEC housing configuration.
Figure 4B is a diagrammatic description of a second possible FADEC housing configuration.
Figure 4C is a diagrammatic description of a third possible FADEC housing configuration.
Figure 4D is a diagrammatic description of a fourth possible FADEC housing configuration.
Figure 5 is a schematic illustration of a method for manufacturing a configurable FADEC housing.

### DETAILED DESCRIPTION

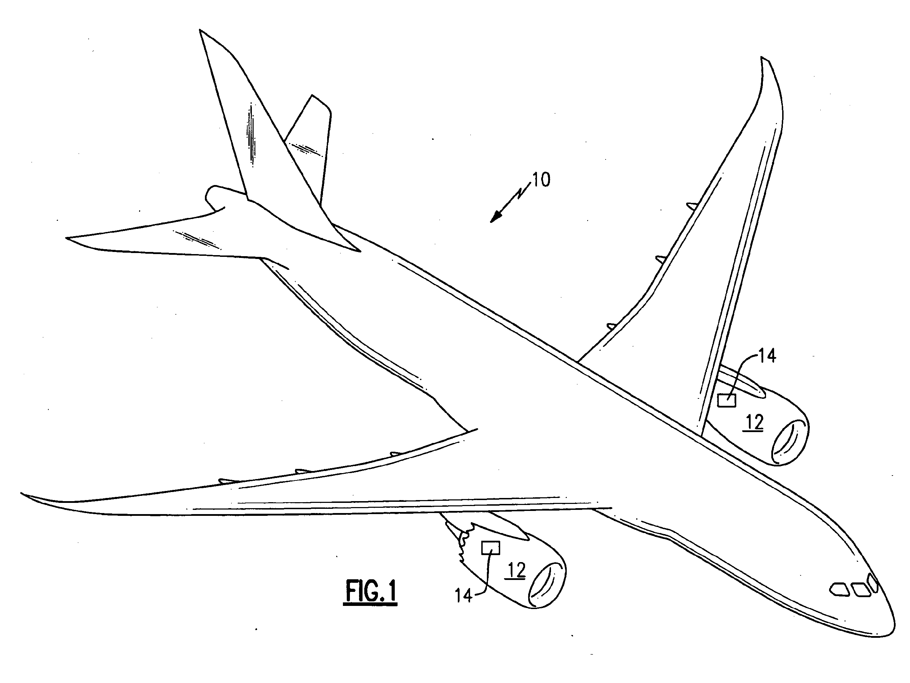

Figure 1 illustrates an aircraft 10, having multiple engines 12, each of which are controlled by a FADEC 14. A single FADEC 14 is used to control each engine 12 in the illustration; however, it is known that multiple engines 12 can be controlled through the utilization of a single multi-channel FADEC. Given their location and purpose, it is desirable to keep the FADEC operational despite environmental factors. While a fixed-wing aircraft 10 is depicted, the system described below is additionally functional in a rotary-wing aircraft, or any other vehicle where digital engine control is desired.

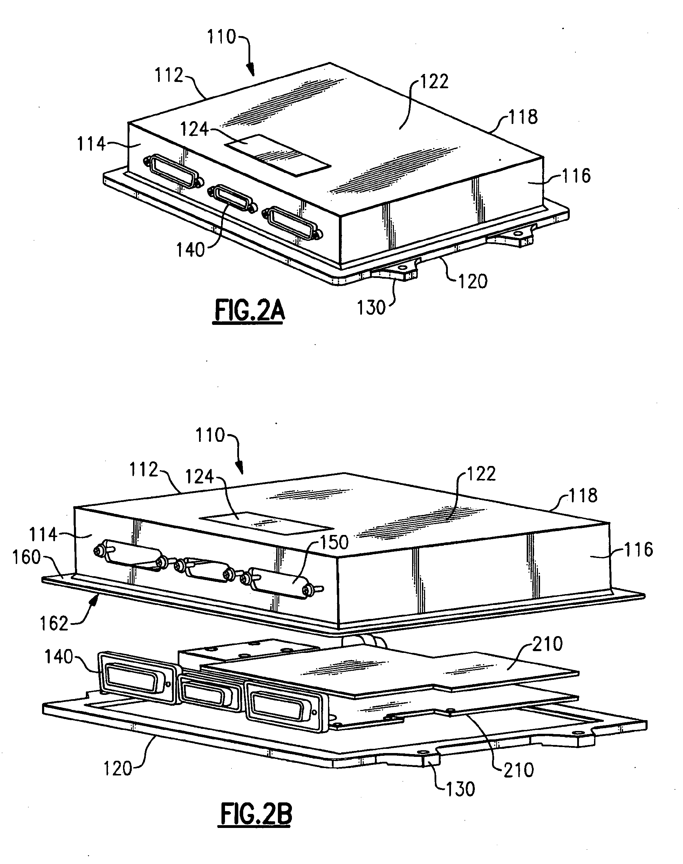

Figures 2A and 2B schematically illustrate a single weatherproof FADEC housing and circuit assembly in an assembled (Figure 2A) and unassembled (Figure 2B) condition. A stamped housing body 110 is formed from a single sheet of metal which has been stamped to a uniform depth. Fitted openings 150 for the connectors 140 are located in a side wall 114 of the housing body 110. A FADEC circuit assembly 210 is placed in the housing body 110, connectors 140 are placed in the fitted openings 150 and connected to the FADEC circuit assembly 210. Additional punch holes 124 can be placed in the base wall of the housing body 110, to allow for base wall mounted electrical connectors 140, or communication wires for connecting to another FADEC circuit. The punch holes 124 can be either fully cut holes where a connector will be placed, or a scored portion of the base wall 122 which can be optionally punched out during assembly. Scoring the punch holes 124 provides additional reconfiguration benefits because scoring allows for connector holes to be readily available should a particular application require them, without requiring other applications to fill a hole should an opening in that location be undesirable.

The housing body 110 also has a sealing lip 160, which surrounds a primary opening 162 in the housing body 110. A cover 120 is sealed to the housing body 110. The cover 120 and the housing body 110 both have mounting features 130, which can be used to mount the FADEC to a vehicle body, or to any other appropriate structure. The illustrated mounting features 130 are tabs capable of being used in conjunction with fasteners. However, any type of mounting feature 130 could be substituted without altering the disclosed functionality. Alternatively, the mounting features 130 could be located on only one of the housing body 110 and the cover 120.

The FADEC housing illustrated in Figures 2A and 2B has a rectangular housing body 110 with four side walls 112, 114, 116, 118, each of which adjoins two other side walls 112, 114, 116, 118. Each of the side walls 112, 114, 116, 118 is also connected to a base wall 122. This structure forms the FADEC housing body 110. The cover 120 is sealed to each of the four side walls 112, 114, 116, 118 after the FADEC circuit assembly 210 has been installed within the housing using known sealing techniques. Alternative shapes having a different number of side walls can also be used depending on the needs of the manufacturer, and the rectangular design is illustrated as an example only.

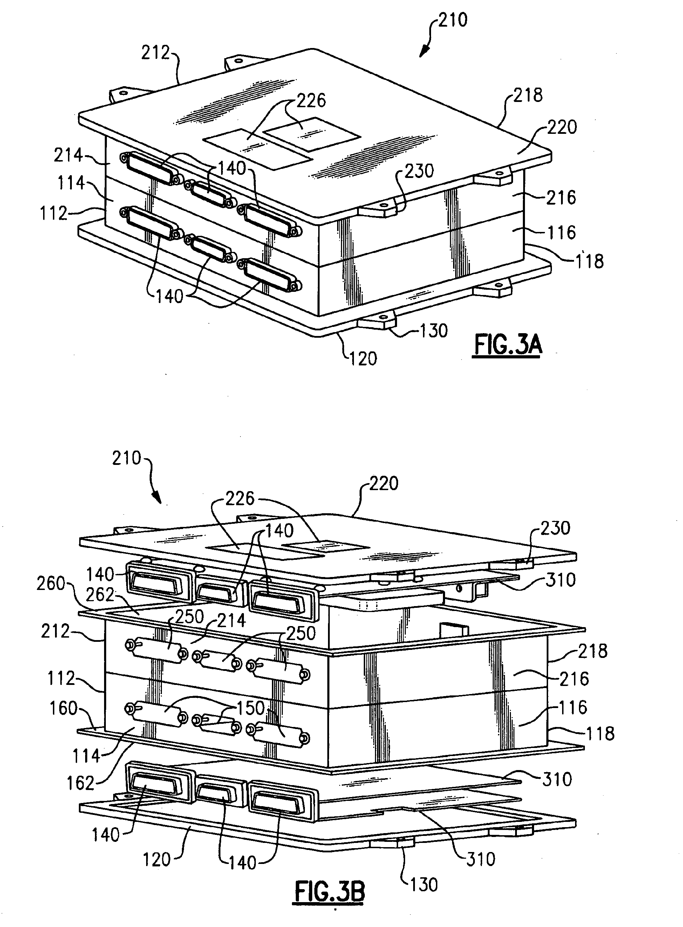

Figures 3A and 3B schematically illustrate another FADEC housing 210 assembled (Figure 3A) and unassembled (Figure 3B) in a second configuration. The second configuration allows for a dual channel FADEC circuit assembly 310 to be assembled within a single housing 210 by stacking two of the FADEC housing bodies 110 illustrated in Figures 2A and 2B, such that their base walls 122 are adjoining. The base walls 122 may be connected via an epoxy adhesive, mechanical fasteners, or any other form of mechanical connection. In such a configuration, each housing body 110 effectively becomes a cover for the other housing body 110.

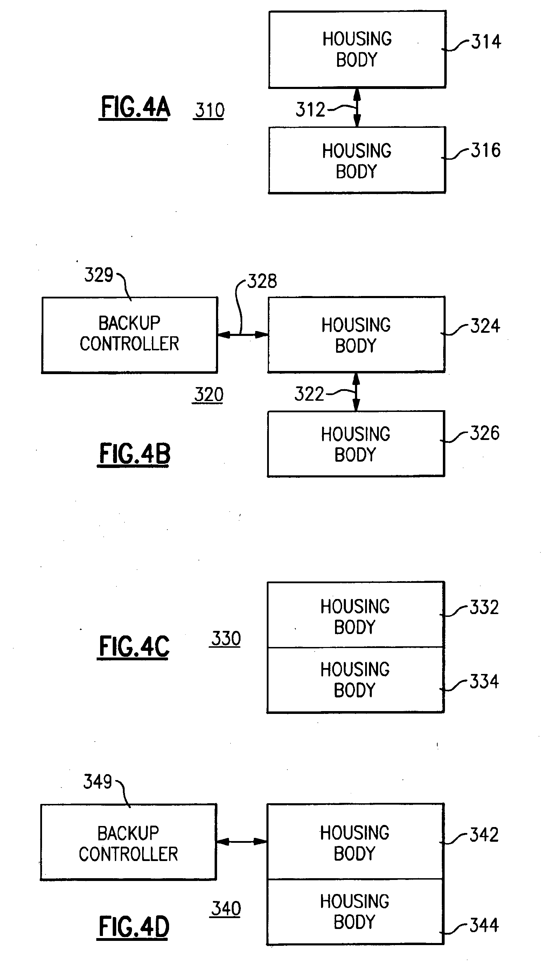

The configurable design of the FADEC housings 110, 210 illustrated in Figures 2A, 2B, 3A and 3B allows the FADEC housing 110, 210 to be arranged in multiple configurations, such as the stacked configuration illustrated in Figure 3A and 3B, as well as at configuration 330 in Figure 4C. Alternatively, an adjacent configuration could be utilized where two FADEC housings are connected via their side walls 112, 114, 116, 118, 212, 214, 216, 218 or with two mechanically unconnected single FADEC housings which are electrically connected via a communication line. Each of the connected housing bodies 110, 210 has fitted holes 150, 250 in which the connectors 140 for the circuit assemblies 310 can be mounted. Each FADEC housing body 110, 210 is enclosed via a cover 120, 220 as in Figures 2A and 2B. Additionally illustrated in Figures 3A and 3B are scored holes 226 on each of the covers 120, 220. The scored holes 226 on the covers 120, 220 provide similar benefits to the scored holes 124 described above with reference to Figures 2A and 2B.

Multiple fastener holes may be placed throughout the sealing lip 160, 260 without harming the integrity of the weather tight seal between the cover 120, 220 and the housing body 110, 210. The presence of multiple fastener holes allows the housing body 110, 210 to be mounted to a variety of structures without requiring the FADEC housing to be redesigned, or physically altered. This aspect further enhances the reconfigurability of the present design. Fitted holes are additionally cut in the side walls thereby forming a housing body 110 with fitted holes 150 for electrical connectors 140.

The FADEC housing bodies 120 are created using a stamping method, described below, which is quicker and cheaper than the currently used milling methods. The stamped and uniform nature of the FADEC housings 110, 210 of this disclosure additionally allows the FADEC housings 110, 210 to be configured in multiple configurations (see Figures 4A-4D), thereby reducing the need for custom designed configurations. The configurable design also allows a manufacturer to purchase identical FADEC housings 110, 210 in bulk and use the FADEC housings 110, 210 in different applications, where each application has different spatial requirements and allowances. This provides a monetary savings as custom designed FADEC housings 110, 210 are no longer required for each project.

The disclosed FADEC housing designs can also include interchannel communication devices (not pictured) mounted on an external portion of the housing body 110. Locating the interchannel communication devices external to the FADEC housing allows for the FADECs to be configured in varying configurations, rather than locking them in a singular configuration for all applications. Furthermore, space is saved within the FADEC housing body 110 as a result of moving the interchannel communication outside of the housing body 110, reducing the required size of the FADEC housing.

Figures 4A-4D illustrate multiple possible configurations for the FADEC housings. Each of the housing bodies in the configurations of Figures 4A-4D has a stamped main body portion, and a cover sealed to the main body, as is described with regard to Figures 2A, 2B, 3A, and 3B above. Contained within the housing body is FADEC circuitry, resulting in an assembled controller. The first configuration 310, illustrated in Figure 4A, has two separate housing bodies 314, 316 and FADEC circuits within each of the housing bodies 314, 316 are coupled together via a communication line 312. The communication line 312 is sent through a sealed electrical connector which is mounted in a punch hole 124 (illustrated in Figures 2A and 2B) in the base wall 122 of the housing body 110, as described with regard to Figures 2A and 2B.

The second configuration 320, illustrated in Figure 4B, adds a backup controller 329, which is electrically coupled to one of the controllers contained in the housing bodies 324, 326 through the standard electrical connectors 140. The housing bodies 324, 326 are arranged in a similar manner to the housings illustrated in Figure 4A.

The third configuration 330, illustrated in Figure 4C, and the fourth configuration 340, illustrated in Figure 4D, each have two housing bodies 332, 334, 342, 344 and are configured a similar manner as the example illustrated in Figures 3A and 3B, with their base walls being physically connected. The FADEC circuits housed within the housing bodies 332, 334, 342, 344 are connected via an internal connector wire which passes through aligned punch holes (such as the punch hole 124 illustrated in Figures 2A and 2B) in the base walls 122 of each housing body. The fourth example configuration 340, Figure 4D, additionally adds a backup controller 349, which is connected to one of the controllers contained within the housing bodies 342, 344 in the same manner as the second example configuration 320. The four illustrated configurations are exemplary only and other configurations could be utilized and still fall within this disclosure.

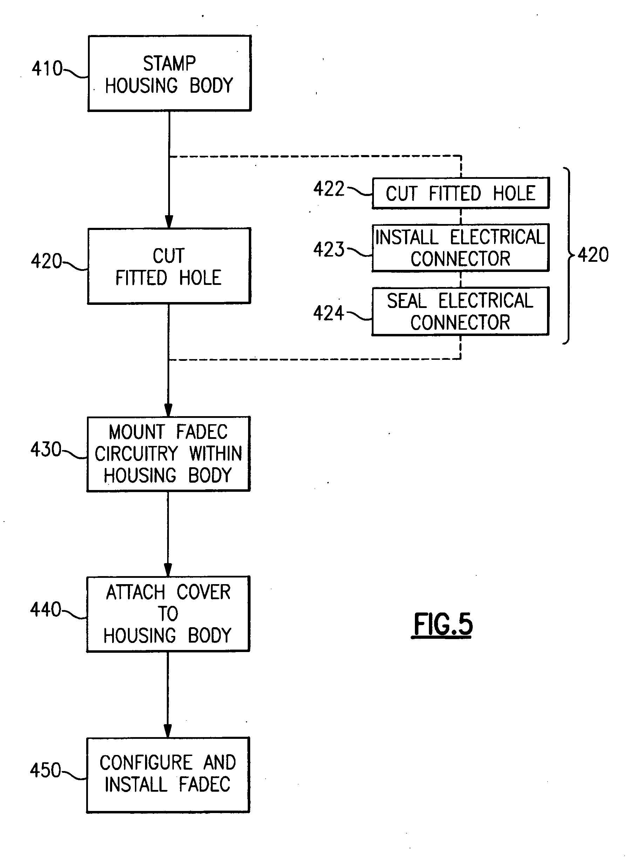

An example method for creating the above described stamped FADEC housings is illustrated in Figure 5. Initially the housing body is stamped in a stamp housing body step 410. Stamping operates by placing a sheet of metal, or another similar material, which the housing body 110, 210 may be constructed out of, between a post and a hole. The post is then pressed into the hole, resulting in a deformed portion of the sheet. The deformed portion is an indent in the sheet. The indent is shaped corresponding to the shapes of the post and the hole. By way of example, if a rectangular indent is desired, the post and the hole would also be rectangular. The stamped indent can then be cut from the sheet to form the FADEC housing body 110, 210. Alternatively each sheet can be used to form a single FADEC housing body 110, 210, resulting in the additional creation of the lip portion 160, 260 encircling the opening 162, 262.

Once the housing body has been stamped to the desired shape, holes are cut into the body for the desired electrical connectors and electrical access in the cut fitted holes step 420. Once the preparatory steps 410 and 420 are finished the electronic circuitry is mounted within the housing body, and connectors are placed in the cut holes and connected to the FADEC circuitry in the mount FADEC circuitry step 430. Alternatively, if a weather tight seal is desired, the connectors 140 can be mounted and sealed into the fitted holes during the cut fitted holes step 420. This results in the cut fitted hole step 420 having a series of three substeps of cutting the fitted hole (substep 422), installing the electrical connector (substep 423), and sealing the electrical connector (substep 424).

Once all of the FADEC circuitry has been mounted, the process moves on to the attach cover step 440. In the attach cover step 440, a cover is mounted to the housing body. The cover can then provide a weather tight seal which protects the FADEC circuitry from exposure. Multiple assembled FADEC housings can be configured as described above with regards to Figures 4A-4D or in alternative configurations and installed in the configure and install FADEC step 450. If the housing bodies utilized have a sealing lip 160, 260 (as illustrated in Figures 2A, 2B, 3A, and 3B) fastener holes in the sealing lip 160, 260 can be lined up with fastener holes in the cover 120, 220 or in the structure on which the FADEC will be mounted. Once lined up, a fastener can be placed through each of the fastener holes, and the cover 120, 220 may be held to the sealing lip 160, 260, or the housing body may be attached to the aircraft structure. Alternatively the cover may be sealed to the housing body using adhesive or any other known attachment method.

Although example embodiments of this invention have been disclosed, a worker of ordinary skill in this art would recognize that certain modifications would come within the scope of this invention. For that reason, the following claims should be studied to determine the true scope and content of this invention.

## Claims

1. A Full Authority Digital Electronic Controller (FADEC) (14) comprising;
a first stamped housing body (110);
a first FADEC circuit assembly (210) supported within said stamped housing body;
at least one electrical connector (140) mounted to said first stamped housing body and communicatively coupled to said first FADEC circuit assembly;
a first cover (120) connected to said first stamped housing body;
a second stamped housing body (210);
a second FADEC circuit assembly (310) supported within said second stamped housing body;
at least one electrical connector (140) mounted to said second stamped housing body and communicatively coupled to said second FADEC circuit assembly; and
a second cover (220) connected to said stamped housing body, wherein said second FADEC circuit assembly is electrically connected to said first FADEC circuit assembly via an electrical coupling (312); and
wherein the FADEC is configurable in at least a first configuration wherein the first and second housing bodies are physically separate housing bodies, and a second configuration wherein base walls of said first and second housing bodies are physically connected together.

2. The FADEC assembly of claim 1, additionally comprising at least one mounting feature (130) for mounting said FADEC assembly to a vehicle body; preferably wherein said mounting feature comprises a tab (130) having a fastener hole; and/or wherein said mounting feature comprises a sealing lip (160) surrounding a main body opening in said first stamped housing body, said sealing lip comprising at least one fastener hole.

3. The FADEC assembly of claim 1 or 2, wherein said first stamped housing body (110) comprises at least one hole (150) for mounting said at least one electrical connector; preferably wherein said electrical connector is mounted in said hole at least partially via a weather tight seal.

4. The FADEC assembly of claim 1, 2 or 3, wherein said first cover (120) is connected to said first stamped housing body (110) via a weather tight seal.

5. The FADEC assembly of any preceding claim, further comprising a backup controller (329) electrically connected to at least one of said first FADEC circuit assembly and said second FADEC circuit assembly via said at least one electrical connector (140).

## Patentansprüche

1. Voll autorisierte digitale elektronische Steuereinrichtung (Full Authority Digital Electronic Controller, FADEC) (14), umfassend:
einen ersten geprägten Gehäusekörper (110);
eine erste FADEC-Schaltungsbaugruppe (210), die in dem geprägten Gehäusekörper getragen wird;
wenigstens einen elektrischen Verbinder (140), der an dem ersten geprägten Gehäusekörper angebracht ist und kommunizierend an die erste FADEC-Schaltungsbaugruppe gekoppelt ist;
eine erste Abdeckung (120), die mit dem ersten geprägten Gehäusekörper verbunden ist;
einen zweiten geprägten Gehäusekörper (210);
eine zweite FADEC-Schaltungsbaugruppe (310), die in dem zweiten geprägten Gehäusekörper getragen wird;
wenigstens einen elektrischen Verbinder (140), der an dem zweiten geprägten Gehäusekörper angebracht ist und kommunizierend an die zweite FADEC-Schaltungsbaugruppe gekoppelt ist; und
eine zweite Abdeckung (220), die mit dem geprägten Gehäusekörper verbunden ist, wobei die zweite FADEC-Schaltungsbaugruppe elektrisch mit der ersten FADEC-Schaltungsbaugruppe über eine elektrische Kopplung (312) verbunden ist; und
wobei die FADEC in wenigstens einer ersten Konfiguration, wobei der erste und zweite Gehäusekörper physisch separate Gehäusekörper sind, und einer zweiten Konfiguration konfigurierbar ist, wobei Basiswände des ersten und zweiten Gehäusekörpers physisch miteinander verbunden sind.

2. FADEC-Baugruppe nach Anspruch 1, außerdem umfassend wenigstens ein Anbringungsmerkmal (130) zum Anbringen der FADEC-Baugruppe an einem Fahrzeugkörper; wobei vorzugsweise das Anbringungsmerkmal eine Lasche (130) mit einer Befestigungsöffnung umfasst; und/oder wobei das Anbringungsmerkmal eine Dichtungslippe (160) umfasst, die eine Hauptkörperöffnung in dem ersten geprägten Gehäusekörper umgibt, wobei die Dichtungslippe wenigstens eine Befestigungsöffnung umfasst.

3. FADEC-Baugruppe nach Anspruch 1 oder 2, wobei der erste geprägte Gehäusekörper (110) wenigstens eine Öffnung (150) zum Anbringen des wenigstens einen elektrischen Verbinders umfasst; wobei vorzugsweise der elektrische Verbinder wenigstens teilweise über eine wetterfeste Dichtung in der Öffnung angebracht ist.

4. FADEC-Baugruppe nach Anspruch 1, 2 oder 3, wobei die erste Abdeckung (120) über eine wetterfeste Dichtung mit dem ersten geprägten Gehäusekörper (110) verbunden ist.

5. FADEC-Baugruppe nach einem der vorangehenden Ansprüche, ferner umfassend eine Sicherungssteuereinrichtung (329), die über den wenigstens einen elektrischen Verbinder (140) elektrisch mit wenigstens einer von der ersten FADEC-Baugruppe und der zweiten FADEC-Baugruppe verbunden ist.

## Revendications

1. Contrôleur électronique numérique à pleine autorité (FADEC) (14) comprenant :
un premier corps estampé de boîtier (110) ;
un premier ensemble pour circuit de FADEC (210) soutenu à l'intérieur dudit corps estampé de boîtier ;
au moins un connecteur électrique (140) monté sur ledit premier corps estampé de boîtier et couplé de manière communicative audit premier ensemble pour circuit de FADEC;
un premier couvercle (120) relié audit premier corps estampé de boîtier ;
un deuxième corps estampé de boîtier (210) ;
un deuxième ensemble pour circuit de FADEC (310) soutenu à l'intérieur dudit deuxième corps de boîtier ;
au moins un connecteur électrique (140) monté sur ledit deuxième corps estampé de boîtier et couplé de manière communicative audit deuxième ensemble pour circuit de FADEC ; et
un deuxième couvercle (220) relié audit deuxième corps estampé de boîtier, ledit deuxième ensemble pour circuit de FADEC étant connecté électriquement audit premier ensemble pour circuit de FADEC par le biais d'un couplage électrique (312) ; et
le FADEC étant configurable selon au moins une première configuration où les premier et deuxième corps de boîtier sont des corps de boîtier physiquement séparés, et selon une deuxième configuration où les parois de base desdits premier et deuxième corps de boîtiers sont physiquement reliés ensemble.

2. Ensemble formant un FADEC selon la revendication 1, comprenant en outre au moins un élément de montage (130) servant à monter ledit ensemble formant un FADEC à une carrosserie de véhicule ; où de préférence ledit élément de montage comprend une patte (130) comportant un trou d'attache et/ou dans laquelle ledit élément de montage comprend une lèvre d'étanchéité (160) entourant une ouverture de corps principal dans ledit premier corps estampé de boîtier, ladite lèvre d'étanchéité comprenant au moins un trou d'attache.

3. Ensemble formant un FADEC selon la revendication 1 ou 2, dans lequel ledit premier corps estampé de boîtier (110) comprend au moins un trou (150) servant à monter ledit au moins un connecteur électrique ; dans lequel de préférence ledit connecteur électrique est monté dans ledit trou au moins en partie par le biais d'un joint étanche aux intempéries.

4. Ensemble formant un FADEC selon la revendication 1, 2 ou 3, dans lequel ledit couvercle (120) est relié audit premier corps estampé de boîtier (110) par le biais d'un joint étanche aux intempéries.

5. Ensemble formant un FADEC selon l'une quelconque des revendications précédentes, comprenant en outre un contrôleur de secours (329) connecté électriquement à au moins soit ledit premier ensemble pour circuit de FADEC soit ledit deuxième ensemble pour circuit de FADEC par le biais dudit au moins un connecteur électrique (140).
